# FASCICULE DE BREVET EUROPEEN

(11) **EP 2 082 632 B1**
(45) Date de publication et mention de la délivrance du brevet: **15.12.2010**
(21) Numéro de dépôt: 07848312.0
(22) Date de dépôt: 03.10.2007
(51) Int. Cl.: H05K 5/06

(54) **BOITIER ELECTRIQUE ET/OU ELECTRONIQUE, NOTAMMENT POUR VEHICULE AUTOMOBILE**
ELEKTRISCHE UND/ODER ELEKTRONISCHE EINHEIT INSBESONDERE FÜR EIN KRAFTFAHRZEUG
ELECTRIC AND/OR ELECTRONIC UNIT, IN PARTICULAR FOR A MOTOR VEHICLE

(30) Priorité: 17.10.2006 FR 0609094
(43) Date de publication de la demande: 29.07.2009
(73) Titulaire: Valeo Etudes Electroniques, 94042 Créteil Cedex (FR)
(72) Inventeur: THIOLLAY, Lionel, 91260 Juvisy-sur-orge (FR); TINGAUD, Stéphane, 94700 Maisons Alfort (FR)
(74) Mandataire: Camus, Olivier Jean-Claude
(86) Numéro de dépôt international: PCT/FR2007/001613
(87) Numéro de publication internationale: WO 2008/046978

(56) Documents cités:
- JP-A- 9 102 679
- US-A- 5 232 758
- US-A- 5 755 026

## Description

La présente invention se rapporte à un boîtier électrique et/ou électronique dans lequel est reçue au moins une carte électronique, par exemple une carte de puissance ou une carte de commande électronique, ladite au moins une carte électronique comportant un premier élément qui se trouve à un premier potentiel électrique et au moins un deuxième élément, à distance du premier élément, qui se trouve à un deuxième potentiel électrique, différent du premier potentiel électrique.

Ces dispositifs formant boîtiers électriques et/ou électroniques de l'art antérieur ont un fonctionnement qui évolue défavorablement au cours du temps, et en particulier s'usent rapidement.

Le document JP 09/102679 décrit un dispositif formant un boîtier électrique et/ou électronique selon le préambule de la revendication 1.

La présente invention vise à surmonter les inconvénients de l'art antérieur en proposant un dispositif formant boîtier électrique et/ou électronique dont la durée de vie moyenne est augmentée et dont le fonctionnement n'évolue pas de manière défavorable au cours du temps.

Suivant l'invention, un dispositif formant boîtier électrique et/ou électronique est tel que défini à la revendication 1, des perfectionnements étant définis aux sous-revendications.

On s'est aperçu pour la première fois que l'électromigration ou migration d'électrons qui est liée à l'humidité qui s'est introduite dans le boîtier, entre les deux éléments se trouvant à un potentiel différent sur la carte de puissance faisait que cette carte de puissance au cours du temps avait un fonctionnement qui évoluait de manière défavorable. En prévoyant maintenant des moyens pour lutter contre l'électromigration, on s'assure que cette carte de puissance fonctionne convenablement plus longtemps et ne nécessite pas d'être changée aussi souvent que dans le cas de l'art antérieur.

Suivant un mode de réalisation préféré de l'invention, les moyens pour lutter contre l'électromigration sont constitués d'un muret d'isolation disposé entre le premier élément et le ou les deuxièmes éléments.

Suivant un mode de réalisation préféré de l'invention, la carte est nappée d'une résine sur la partie supérieure, c'est-à-dire la partie où se trouvent les éléments électriques et le muret.

Suivant un mode de réalisation préféré de l'invention, la base du muret, c'est-à-dire la partie du muret destinée à se trouver du côté de la carte, est noyée dans de la résine, notamment pour assurer une isolation encore meilleure des zones à potentiels différents. En particulier on s'assure que les murets sont étanches vis-à-vis de l'humidité.

Suivant un mode de réalisation préféré de l'invention, les premiers éléments sont des fusibles, tandis que les deuxièmes éléments sont des fusibles à la masse.

Suivant un mode de réalisation préféré de l'invention, le muret d'isolation est en une matière isolante, notamment thermoplastique, par exemple en polyéthylène PE, polypropylène PP, et analogues.

Suivant un mode de réalisation préféré, un joint, notamment en silicone, est appliqué entre la base du muret et la carte, de préférence des deux côtés du muret. Suivant un mode de réalisation particulièrement étanche, le muret est issu d'une pièce, par exemple moulé, avec le couvercle.

On décrit maintenant, uniquement à titre d'exemple, un mode de réalisation préféré de l'invention en se reportant aux dessins dans lesquels :
la figure 1 est une vue en coupe d'une partie d'un boîtier électronique suivant l'invention ; et
la figure 2 est une vue en coupe longitudinale d'un boîtier à un niveau au-dessus de la carte PCB qu'il contient et qui comporte plusieurs zones à potentiels différents séparées les unes des autres par plusieurs murets.

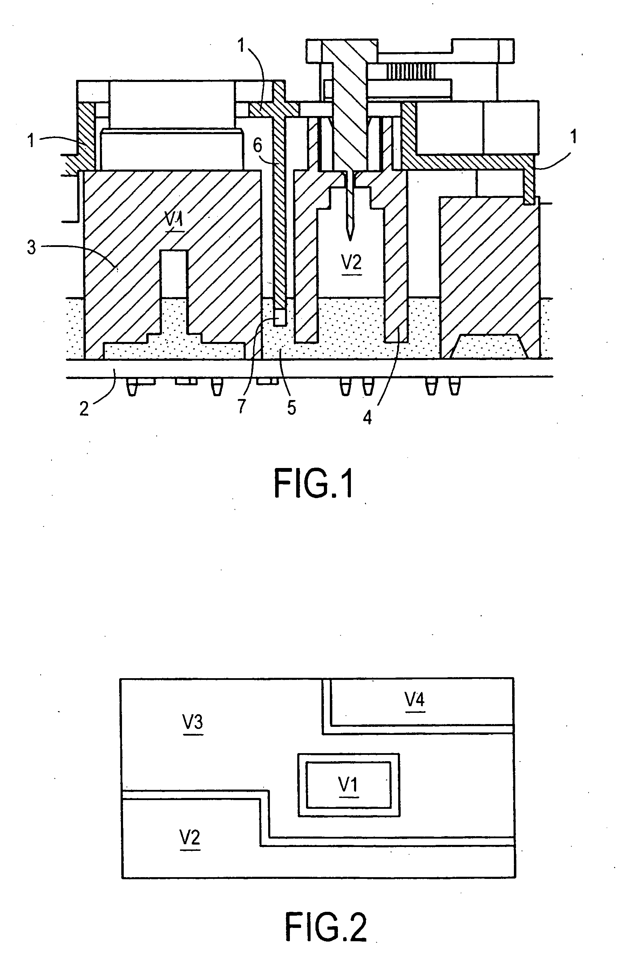

A la figure 1, il est représenté une partie supérieure d'un boîtier électrique et/ou électronique suivant l'invention. Dans ce boîtier, dont on ne voit à la figure qu'une partie du couvercle 1, est reçue une carte 2 de puissance sur laquelle sont implantés un premier élément 3 sous la forme d'un fusible se trouvant à un potentiel V1 et un deuxième élément 4 se trouvant à un deuxième potentiel V2, notamment nul, correspondant à la masse. Ce deuxième élément 4 peut, par exemple, être un fusible relié à la masse, tandis que le premier élément 3 est un fusible relié au + de la batterie. En dessous, la carte 2 de puissance est reliée à une carte de commande (non représentée) par l'intermédiaire d'un bus (non représenté), l'ensemble étant reçu dans le boîtier dont on ne voit à la figure que le couvercle 1. La carte 2 de puissance est nappée d'une couche de résine 5 (représentée à la figure sous la forme de traits entrecroisés). Entre l'élément 3 au potentiel électrique V1 et le ou les éléments 4 au potentiel V2, différent du potentiel V1 et notamment égal à 0, il est disposé un muret 6 sensiblement vertical dont la base 7 est noyée dans la résine sans pour autant atteindre la carte 2. Ce muret 6 s'étend verticalement depuis la résine jusqu'au couvercle 1. Au niveau de son bord supérieur, au niveau du couvercle 1, le muret 6 est issu du couvercle, notamment de moulage. Ceci permet de lutter encore mieux contre l'électromigration entre les deux éléments 3 et 4. Le muret est en un matériau isolant, notamment en polyéthylène.

Le muret s'étend également, dans la direction en largeur (c'est-à-dire dans la direction perpendiculaire à la figure) de préférence depuis une des parois latérales du boîtier jusqu'à l'autre paroi latérale du boîtier, de sorte que le muret définit à gauche et à droite, entre la carte 2 et le couvercle 1, au moins deux espaces ou volumes fermés dans lesquels se trouvent respectivement les deux ou plus de deux éléments électriques 3 et 4.

A la place des fusibles, d'autres composants peuvent être prévus, par exemple des relais, des capacités et analogues.

A la figure 2, on voit de dessus schématiquement une carte comportant quatre zones chacune à un potentiel V₁, V₂, V₃ et V₄ respectif.

Chaque zone est isolée des autres zones par des murets.

Les éléments 3 et 4 font saillie hors de la couche de résine 5 de sorte qu'ils ne sont pas recouverts au moins sur le dessus par celle-ci.

## Revendications

1. Dispositif formant un boîtier électrique et/ou électronique, dans lequel est reçue au moins une carte (2), notamment une carte de puissance, comportant un premier élément (3) se trouvant à un premier potentiel électrique et au moins un deuxième élément (4) à distance du premier élément et se trouvant à un deuxième potentiel électrique différent du premier potentiel électrique, des moyens pour lutter contre la migration d'électrons entre le premier élément et au moins un deuxième élément étant prévus, les moyens pour lutter contre l'électromigration étant constitués d'au moins un muret (6) d'isolation disposé entre le premier élément (3) et le ou les deuxièmes éléments (4),
**caractérisé en ce que** la carte est nappée d'une résine (5) sur sa partie supérieure, c'est-à-dire la partie où se trouvent les éléments électriques et le muret, et les éléments électriques ne sont pas recouverts par la résine.

2. Dispositif formant un boîtier suivant la revendication 1, **caractérisé en ce que** la base (7) du muret, c'est-à-dire la partie du muret destinée à se trouver du côté de la carte, est noyée dans la résine, notamment pour assurer sa fixation sensiblement verticale par rapport au plan de la carte.

3. Dispositif formant un boîtier suivant l'une des revendications 1 à 2, **caractérisé en ce que** le premier élément est un fusible, tandis que le ou les deuxièmes éléments sont des fusibles à la masse.

4. Dispositif formant un boîtier suivant l'une des revendications 1 à 3, **caractérisé en ce que** le muret (6) d'isolation est en une matière isolante, notamment en matière plastique, notamment thermoplastique.

5. Dispositif formant un boîtier suivant l'une des revendications précédentes, **caractérisé en ce que** le muret est issu d'une pièce, notamment par moulage, d'un couvercle du boîtier.

## Claims

1. Device forming an electric and/or electronic unit, in which at least one card (2) is accommodated, in particular a power card, comprising a first element (3) at a first electric potential and at least one second element (4) remote from the first element and at a second electric potential which differs from the first electric potential, means being provided for combating against the migration of electrons between the first element and at least one second element, the means for combating against the electromigration consisting of at least one insulating wall (6) arranged between the first element (3) and the second element(s) (4), **characterised in that** the card is coated with a resin (5) over its upper part, i.e. the part where the electrical elements and the wall are located and the electrical elements are not covered by the resin.

2. Device forming a unit according to Claim 1, **characterised in that** the base (7) of the wall, i.e. the part of the wall intended to be located on the side of the card, is embedded in the resin, in particular to enable it to be fixed substantially vertically relative to the plane of the card.

3. Device forming a unit according to one of Claims 1 to 2, **characterised in that** the first element is a fuse, whilst the second element(s) are earthed fuses.

4. Device forming a unit according to one of Claims 1 to 3, **characterised in that** the insulating wall (6) is made of an insulating material, in particular made of plastics material, in particular thermoplastic material.

5. Device forming a unit according to one of the preceding claims, **characterised in that** the wall is made in one piece, in particular by moulding, with a cover of the unit.

## Patentansprüche

1. Ein elektrisches und/oder elektronisches Gehäuse formende Vorrichtung, in welcher mindestens eine Karte (2), insbesondere eine Leistungskarte aufgenommen wird, umfassend ein erstes Element (3), das ein erstes elektrisches Potential aufweist, und mindestens ein zweites Element (4), das vom ersten Element beabstandet ist und ein zweites elektrisches Potential aufweist, das anders ist als das erste elektrische Potential, wobei Mittel vorgesehen sind, um die Elektronenmigration zwischen dem ersten Element und mindestens einem zweiten Element zu bekämpfen, und wobei diese Mittel zur Bekämpfung der Elektronenmigration aus mindestens einer Isolierwand (6) bestehen, die zwischen dem ersten Element (3) und dem oder den zweiten Element(en) (4) angeordnet ist,
**dadurch gekennzeichnet, dass** die Karte auf ihrer Oberseite, das heißt, auf der Seite, wo die elektrischen Elemente und die Wand angeordnet sind, mit einem Harz (5) überzogen sind, und die elektrischen Elemente nicht mit Harz überzogen sind.

2. Gehäuseformende Vorrichtung nach Anspruch 1, **dadurch gekennzeichnet, dass** die Basis (7) der Wand, das heißt, der Teil der Wand, der kartenseitig liegt, im Harz versenkt ist, insbesondere, um seine Befestigung im Wesentlichen senkrecht zur Kartenebene zu gewährleisten.

3. Gehäuseformende Vorrichtung nach einem der Ansprüche 1 bis 2, **dadurch gekennzeichnet, dass** das erste Element eine Sicherung ist, während das oder die zweiten Elemente Massesicherungen sind.

4. Gehäuseformende Vorrichtung nach einem der Ansprüche 1 bis 3, **dadurch gekennzeichnet, dass** die Isolierwand (6) aus einem isolierenden Material ist, insbesondere aus Kunststoff, insbesondere aus Thermoplastkunststoff.

5. Gehäuseformende Vorrichtung nach einem der vorherigen Ansprüche, **dadurch gekennzeichnet, dass** die Wand aus einem Stück ist, insbesondere durch Formung eines Deckels des Gehäuses.
